(19) Europäisches Patentamt
European Patent Office
Office européen des brevets

(11) **EP 4 204 902 B1**

(12) **EUROPEAN PATENT SPECIFICATION**

(45) Date of publication and mention of the grant of the patent:
**30.04.2025 Bulletin 2025/18**

(21) Application number: **21766454.9**

(22) Date of filing: **20.08.2021**

(51) International Patent Classification (IPC):
**G03F 7/20** *(2006.01)* **G02B 26/08** *(2006.01)*

(52) Cooperative Patent Classification (CPC):
**G03F 7/70075; G02B 5/0891; G02B 26/0858; G03F 7/70116; G03F 7/702**

(86) International application number:
**PCT/EP2021/073181**

(87) International publication number:
**WO 2022/043226 (03.03.2022 Gazette 2022/09)**

(54) **PUPIL FACET MIRROR FOR AN ILLUMINATION OPTICAL UNIT OF A PROJECTION EXPOSURE APPARATUS**

PUPILLENFACETTENSPIEGEL FÜR EINE BELEUCHTUNGSOPTIK EINER PROJEKTIONSBELICHTUNGSANLAGE

MIROIR À FACETTES PUPILLAIRES POUR UNE UNITÉ OPTIQUE D'ÉCLAIRAGE D'UN APPAREIL D'EXPOSITION PAR PROJECTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.08.2020 DE 102020210829**

(43) Date of publication of application:
**05.07.2023 Bulletin 2023/27**

(73) Proprietor: **Carl Zeiss SMT GmbH**
**73447 Oberkochen (DE)**

(72) Inventors:
• **WINKLER, Alexander**
**89520 Heidenheim (DE)**
• **ENDRES, Martin**
**89551 Königsbronn (DE)**
• **PATRA, Michael**
**73447 Oberkochen (DE)**
• **RAMOLLA, Michael**
**73447 Oberkochen (DE)**
• **ISAAC, Annie**
**73447 Oberkochen (DE)**
• **FISCHER, Thomas**
**73431 Aalen (DE)**

(74) Representative: **Rau, Schneck & Hübner**
**Patentanwälte Rechtsanwälte PartGmbB**
**Königstraße 2**
**90402 Nürnberg (DE)**

(56) References cited:
**US-A1- 2010 309 449      US-A1- 2013 100 429**
**US-A1- 2016 342 094**

**Description**

The invention relates to a pupil facet mirror for an illumination optical unit of a projection exposure apparatus. Further, the invention relates to an illumination optical unit comprising such a pupil facet mirror, an illumination system comprising such an illumination optical unit, a projection exposure apparatus comprising such an illumination system, and various methods for adjusting at least one facet mirror of such an illumination system.

Various variants of pupil facet mirrors for an illumination optical unit of a projection exposure apparatus are known from US 9,791,785, WO 2011/091900 A1 and the references cited therein. US 2016/0342094 A1 discloses a method for illuminating an object field of a projection exposure system. US 2013/0100429 A1 discloses an optical system and a multi facet mirror of a microlithographic projection exposure apparatus. US 2010/0309449 A1 discloses an illumination system for a microlithographic projection exposure apparatus.

It is an object of the present invention to develop a pupil facet mirror of the type set forth at the outset, in such a way that its use in the illumination optical unit leads to increased flexibility of use of the illumination optical unit and, in particular, facilitates the observation of exacting illumination parameter specifications of the projection exposure apparatus.

According to the invention, this object is achieved by a pupil facet mirror comprising the features specified in Claim 1.

According to the invention, it was recognized that a tilt actuator system which firstly facilitates the specification of a coarse tilt angle by way of a coarse actuator system mode of operation and secondly facilitates the specification of a fine tilt angle of the tiltable pupil facets via a fine actuator system mode of operation leads to a very flexibly utilizable pupil facet mirror. The tilt actuator system can be separated into a coarse actuator system for the coarse actuator system mode of operation and into a fine actuator system for the fine actuator system mode of operation. Such a separation of an actuator system into two sub-actuator systems with different actuator ranges and usually also different actuator accuracies is also referred to as the use of a long-range actuator (coarse actuator system) and short-range actuator (fine actuator system). The coarse actuator system can be realized by way of actuators which interact with tilt stops of the respective tiltable pupil facet. Corresponding actuators are known in conjunction with switchable field facets. The fine actuator system of the tilt actuator system for the pupil facets can be realized by way of piezo-actuators, in particular piezo-stacks. A corresponding piezo-stack actuator system is known from WO 2011/091900 A1.

Alternatively, such a tilt actuator system can also be realized by means of a single actuator, which can be operated both in the coarse actuator system mode of operation and in the fine actuator system mode of operation. This actuator then combines the actuator range of the coarse tilt angle adjustment in the coarse actuator system mode of operation with the actuator resolution or actuator accuracy of the fine tilt angle adjustment of the fine actuator system mode of operation.

If only a single actuator is used to implement a coarse tilt angle adjustment and a fine tilt angle adjustment, the coarse tilt angle adjustment facilitates a switch over to another illumination channel, i.e., to a guidance of illumination radiation via a different pair consisting of a field facet and a pupil facet. The fine tilt angle adjustment allows the illumination radiation to continue to be guided via the same pair consisting of a field facet and a pupil facet. Wherever reference is made to a coarse actuator system or a fine actuator system below, this also means coarse tilt angle adjustments in the coarse actuator system mode of operation and fine tilt angle adjustments in the fine actuator system mode of operation of one and the same tilt actuator system.

In particular, a pupil fill ratio of freely specifiable illumination pupils of the illumination optical unit can be minimized; i.e., it is possible to arrive at the situation where not only does illumination light fall on an object field of the projection exposure apparatus only from as few as possible, clearly defined directions but also it is also possible for the user of the projection exposure apparatus to choose these few directions such that an optimal imaging behaviour arises. The effective pupil fill ratio (PFR), which is a measure of what pupil area of an illumination pupil is covered by illumination light, represents an illumination parameter which can be specified flexibly and within exacting tolerances by way of an illumination optical unit with the pupil facet mirror according to the invention. A person skilled in the art finds details in respect of the pupil fill ratio in WO 2019/149462 A1 and US 10,018,917, and in the references cited therein. Depending on the requirements placed on the illumination optical unit, a particularly small pupil fill ratio may be preferred. The object then is to use the illumination light guided over as many illumination channels as possible for illumination purposes but in the process only cover regions of the illumination pupil that are as small as possible, which in fact ensure a contrast that is as good as possible or a NILS (normalized image log slope, derivative of an aerial image intensity curve at an edge position of an imaged structure) value that is as good as possible.

In addition to a tilt displaceability, the pupil facets may also be displaceable perpendicular to the reflection surface thereof as a matter of principle. A corresponding displaceability is known from WO 2011/091900 A1.

The option of a dynamic actuation of the pupil facets by way of the tilt actuator system of the pupil facet mirror ensures an individual assignment solution of field facets to the pupil facets via the respective illumination channels, which respectively depends on the illumination setting to be specified. Such an illumination setting-individual solution is not possible in the case of non-actuatable pupil facets.

Tilt angle ratios according to Claim 2 have proven their worth for dividing the functions of, firstly, the coarse actuator system and, secondly, the fine actuator system of the tilt actuator system of the pupil facet mirror. A ratio between the maximum specifiable coarse tilt angle range and the maximum specifiable fine tilt angle range can be greater than 10, can be greater than 20, can be greater than 25, can be greater than 50, can range between 50 and 60, can be greater than 60 and can also be greater than 100. This ratio is regularly less than 1000. Absolute coarse tilt angles can lie in the region around 10°, for example range between 1° and 20° or range between 5° and 15°. Absolute fine tilt angles can lie in the region around 0.1°, by way of example range between 0.01° and 0.9° or range between 0.05° and 0.5°. The advantages of an illumination optical unit according to Claim 3 and an illumination system according to Claim 4 correspond to those which were already explained above in conjunction with the pupil facet mirror.

In addition to the two facet mirrors, the illumination optical unit can still comprise a transmission optical unit for overlaid imaging of the field facets into the object field. Such a transmission optical unit can comprise one or more mirrors for the illumination light. Alternatively, such a transmission optical unit can also be dispensed with, i.e., the downstream facet mirror in the beam path can be the last illumination light-guiding optical component of the illumination optical unit upstream of the object field.

In addition to the illumination optical unit, the illumination system can also comprise a collector for illumination light emanating from a source volume of the light source. In principle, the light source can also be part of the illumination system.

The switchable field facets of the illumination optical unit can be designed in such a way that, by way of one field facet, a plurality of pupil facets can be assigned via a respective illumination channel, for example two, three, four, five or even more pupil facets. In principle, it is possible to embody at least some of the switchable field facets in such a way that, via these, all pupil facets can be assigned to this field facet via illumination channels by means of appropriate switching positions of the field facet. In this case, each pupil facet of the pupil facet mirror can be impinged by illumination light by way of one and the same field facet depending on the switching position of the field facet.

The coarse actuator system of the tilt actuator system of the pupil facet mirror can be used to tilt pupil facets, which can be assigned to a plurality of field facets in corresponding field facet switch positions, in a manner adapted to the relative position of the respective field facet and in such a way that the illumination channel corresponding to this field facet/pupil facet assignment then leads to a field facet image that is guided into the object field. Then, a fine adjustment of this relative field facet image position relative to the object field can still be ensured by way of the fine actuator system.

Switchable pupil facets can be realized by way of the coarse actuator system, in particular analogously to the switchable field facets.

Energy sensors according to Claim 5 have proven their worth for monitoring the performance of the light source and the illumination optical unit.

A field intensity specification device according to Claim 6 allows the illumination intensity over the object field, in particular over a coordinate perpendicular to an object displacement direction or scanning direction of the object, to be adapted in its profile along this field coordinate to a specification value and, in particular, to be designed to be uniform. The illumination intensity along this field coordinate perpendicular to the scanning direction can deviate from a mean value by, for example, less than 2% or else by less than 1%. Alternatively, a specified field intensity curve along this field coordinate can also be set. In particular, this field intensity specification can be implemented in illumination angle-independent fashion. It is also possible to make the field intensity specification field-dependent in a targeted manner.

In principle, a field intensity specification device is known from WO 2011/091900 A1.

A far field sensor according to Claim 7 allows determination as to which field facets of the illumination optical unit are impinged with higher illumination intensity levels and which field facets are impinged with lower illumination intensity levels. Depending on this, illumination channel assignments can then be specified in order to observe certain illumination parameters within specified tolerances. As an alternative or in addition to such a far field sensor, it is possible to use a pupil measurement in the image plane, i.e., in the arrangement plane of a wafer, on which the object field is imaged. To this end, an object with a pinhole or a slot, which is also referred to as measurement fiducial, can be used in the image plane. This renders a far field reconstruction possible, optionally taking account of apodizations of the measurement fiducial and of the imaging optical unit and of the beam path of the illumination light. As an alternative or in addition thereto, an illumination of the field facets may be possible for the spatially resolved prediction of a far field of the illumination light source by virtue of said field facets being switched on the far field sensors or switched away therefrom by way of appropriate switching of the associated respective pupil facet by way of the tilt actuator system.

A relative source position sensor according to Claim 8 can be used to capture a movement of the source volume relative to the collector of the illumination system and compensate the latter in respect of its effect on an object field illumination by way of appropriate tilting of the pupil facets and/or the field facets at least in parts.

The advantages of a fine tilt actuator system for the switchable field facets according to Claim 9 correspond to those already explained above with reference to the fine actuator system for the pupil facets. Field facets displaceable by way of a fine actuator system can be used to optimize a positioning of source images on the pupil facets assigned by illumination channels.

Moreover, facet-dependent mechanical tolerances of the illumination optical unit can be at least partly compensated by way of the fine actuator system for pupil facets and/or for the field facets.

In particular, the illumination channel specification can be implemented on the basis of the respective illumination setting of the illumination system and/or can be implemented on the basis of an intensity profile of the illumination light over the field facets assigned to the illumination channels.

The advantages of a projection exposure apparatus according to Claim 10 correspond to those already explained above with reference to the illumination system.

The method according to Claim 11 allows the energy sensors of the illumination system according to Claim 5 to be used particularly well for monitoring illumination parameters of the illumination system. An illumination parameter relevant in this case can be an illumination light dose radiated in level with the object plane, i.e., at the level of the reticle. The dose radiated onto the energy sensors, which captures right and left sections of images of the field facets of a number of field facets that is as large as possible, can be used as an estimate for the dose of the entire object field. In particular, the energy sensors can be operated in their optimized sensitivity range. A sensitivity of jitter or drift movements of the far field over the field facet mirror in particular can be reduced by a suitable specification of the illumination channels using this adjustment method.

An adjustment method according to Claim 12 facilitates a precise function of the field intensity specification device of the illumination system according to Claim 6. This can implement either targeted influencing of the illumination intensity, where possible independently of the illumination angle, or else implement a targeted field-dependent profile of an illumination intensity distribution over the object field.

In principle, such an adjustment method can also be used in the case of a field intensity specification device which does not have shadowing fingers that are individually displaceable by way of an actuator but, for example, has a single static field stop.

What is exploited in a method according to Claim 13 is that a tilt of a pupil facet by way of the fine actuator system about an axis parallel to the longitudinal axis of the shadowing finger can nevertheless lead to a change in distance between the field facet image and the free end of the shadowing finger in the case of a field facet image which has a curved profile in particular. Such a tilt regularly leads to a displacement of the field facet image perpendicular to the object displacement direction, which can be used to specify certain field-dependent illumination intensity parameters.

In particular, the parameters of EPE, ellipticity, telecentricity, NILS (normalized image log slope, derivative of an aerial image intensity curve at an edge position of an imaged structure), throughput and uniformity come into question as adjustable illumination parameters. A person skilled in the art finds details in respect of the ellipticity parameter in US 9,625,827. A person skilled in the art finds details in respect of the NILS parameter and in respect of the telecentricity parameter in US 2015/0042974 A1. The throughput parameter denotes the energy throughput of the illumination optical unit, i.e., the ratio of the entire illumination light energy downstream of the illumination optical unit to the energy upstream of the illumination optical unit. A person skilled in the art finds details in respect of the uniformity parameter in, for example, EP 0 952 491 A2 and also US 8,705,000. EPE is an abbreviation for edge placement error, i.e., the deviation between the desired position of an edge in the aerial image (or final structure on the wafer) and the actual position thereof. Since the variable relates to a single edge it is very generic. By way of example, no distinction is made whether the edge offset is caused by broadening of the structure (CD error) or a simple displacement of the structure (overlay error, or telecentricity error if generated via the defocus of the wafer). A relatively current article considering EPE in the EUV range, albeit with a focus on the mask layout, is the following:

J. of Micro/Nanolithography, MEMS, and MOEMS, 17(4), 041008 (2018). https://doi.org/10.1117/1.JMM.17.4.041008

An adjustment method according to Claim 14 allows specification of an illumination channel assignment, in such a way that specified illumination parameters can be realized. In addition to the coarse actuator-based displacement of the field facets and the pupil facets, there can still additionally be a fine actuator-based displacement of these facets for fine adjustment purposes.

Assessment functions, discussed in, e.g., US 9,791,785, can be included within the scope of the illumination channel assignment.

An adjustment method according to Claim 15 takes account of a possible source volume displacement. As a controlled method, the method can ensure automatic tracking of the facets relative to a respectively captured relative position of the source volume. Thus, this adjustment method can be designed as a real-time closed-loop control method.

The methods according to Claims 11 to 15 can also be used in any combination. After selecting an illumination setting, implemented in particular in a manner adapted to the structures of the object to be implemented, the method according to Claim 14 can initially be used to realize the illumination setting. The further methods according to Claims 11 and/or 12 and/or 13 and/or 15 can then optionally be used simultaneously as co-optimization in order to optimize an object illumination in respect of further parameters, for example energy sensor sensitivity, crosstalk of a field intensity specification device.

Initially, at least one of the above-explained adjustment methods can be used to produce microstructured/nanostructured components with the aid of such a projection exposure apparatus. Subsequently, a wafer is provided, to which a layer made of a light-sensitive material is partly applied. Moreover, a reticle, which has structures to be imaged, is provided. At least part of the reticle is imaged, i.e., projected, onto a region of the layer of the wafer with the aid of the projection exposure apparatus. Then, the microstructured or nanostructured component arises after developing the light-sensitive layer. This can be a semiconductor chip, in particular a memory chip.

At least one exemplary embodiment of the invention is described below on the basis of the drawing. In the drawing:

Fig. 1　schematically shows a meridional section of a projection exposure apparatus for EUV projection lithography;

Fig. 2　very schematically shows a field facet of a field facet mirror of an illumination optical unit of the projection exposure apparatus and a pupil facet assigned to the field facet via an illumination channel and a field facet image in the region of an object plane of the projection exposure apparatus, illustrated in a first fine actuator system tilt position of the pupil facet, in which an energy sensor illustrated to the right in Figure 2 overlaps with the field facet image;

Fig. 3　shows, in an illustration similar to Figure 2, a change in relative position of the field facet image after a fine actuator system tilt of the pupil facet such that the field facet image overlaps with an energy sensor illustrated to the left in the figure;

Fig. 4　shows an illustration similar to Figures 2 and 3, wherein relative position tolerances of the left and the right upper corner of the field facet image and adjustment degrees of freedom of the fine actuator system of the pupil facet mirror are highlighted;

Fig. 5　shows very schematically a pupil facet of the illumination optical unit in two tilt positions and the object field of the projection exposure apparatus including a plurality of illumination channels corresponding to field facet images overlapping herein, and additionally shows a shadowing finger of a field intensity specification device and, schematically, the effect of various fine actuator system adjustment positions of pupil facets of the illumination optical unit and of positions of the shadowing fingers on a quadrupole illumination setting of the illumination optical unit;

Fig. 6　shows a field facet image in the region of the object field of the projection exposure apparatus specified by a scan slot, including a stop effect of the field intensity specification device which does not shadow this field facet image;

Fig. 7　shows, in an illustration similar to Figure 6, the field facet image in a laterally displaced relative position which results from a fine actuator-based tilt of the associated pupil facet, wherein, in the relative position of the field facet image according to Figure 7, the latter is shadowed in an edge region, top left in Figure 7, by a stop of the field intensity specification device;

Fig. 8　very schematically shows two field facets of a field facet mirror of the illumination optical unit of the projection exposure apparatus, with in each case two pupil facets of a pupil facet mirror of the illumination optical unit assigned via an illumination channel;

Fig. 9　schematically shows an impingement of the first pupil facet of the illumination channel assignment according to Figure 8 with an illumination light chief ray for elucidating an angle of incidence;

Fig. 10　shows, in an illustration similar to Figure 9, the impingement of the second pupil facet of the illumination channel assignment according to Figure 8 with the illumination light chief ray;

Fig. 11　shows, in an illustration similar to Figure 8, an alternative illumination channel assignment of the two field facets to the two pupil facets, generated by a switch of the two field facets and a subsequent coarse actuator-based tilt of the pupil facets;

Fig. 12　shows the pupil facet according to Figure 9 in the chief ray impingement situation of the illumination channel assignment according to Figure 11;

Fig. 13　shows the pupil facet according to Figure 10 in the chief ray impingement situation of the illumination channel assignment according to Figure 11;

Fig. 14     shows, once again schematically, an illumination channel of a further embodiment of an illumination optical unit of the projection exposure apparatus between a source volume of an EUV light source of the projection exposure apparatus and an object field in an object plane;

Fig. 15     schematically shows assignment variants between two different field facets of the field facet mirror and exactly one pupil facet of the pupil facet mirror for the purposes of elucidating a coarse tilt angle range of a tilt actuator system of the pupil facet mirror; and

Fig. 16     shows, in a schematic illustration similar to Figure 15, an illumination light beam path between exactly one of the pupil facets and the object field for the purposes of elucidating a fine tilt angle range of the tilt actuator system of the pupil facet mirror.

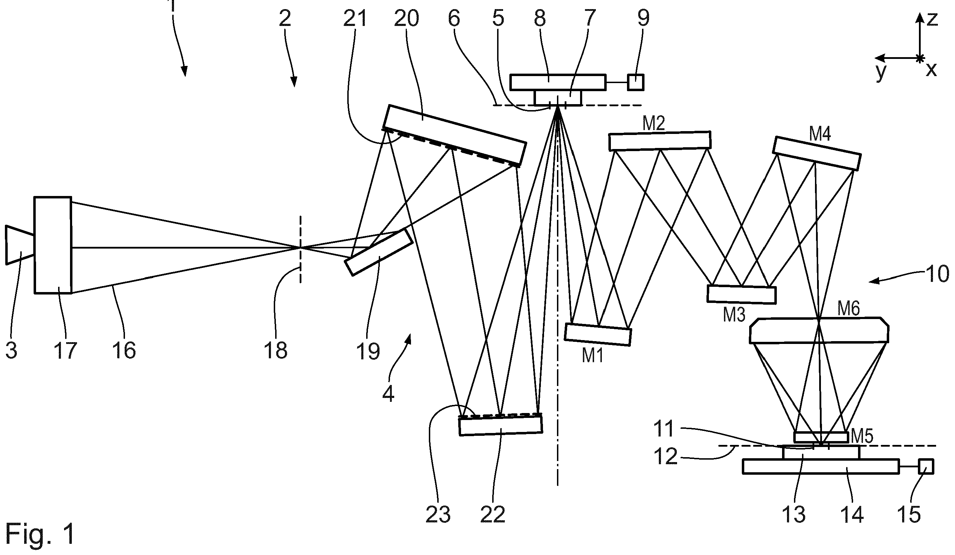

In the following text, the essential components of a microlithographic projection exposure apparatus 1 are described first by way of example with reference to Figure 1. The description of the basic construction of the projection exposure apparatus 1 and its components should not be construed as limiting here.

An illumination system 2 of the projection exposure apparatus 1 has, besides a radiation source 3, an illumination optical unit 4 for illuminating an object field 5 in an object plane 6. In this case, a reticle 7 arranged in the object field 5 is exposed. The reticle 7 is held by a reticle holder 8. The reticle holder 8 is displaceable by way of a reticle displacement drive 9, in particular in a scanning direction.

A global Cartesian xyz-coordinate system is shown in Figure 1 for explanation purposes. The x-direction extends perpendicular to the plane of the drawing. The y-direction extends horizontally, and the z-direction extends vertically. The scanning direction extends along the y-direction in Figure 1. The z-direction extends perpendicular to the object plane 6.

In the subsequent figures, a local xy- or xyz-coordinate system is optionally used for elucidation purposes. The x-direction of the respective local coordinate system corresponds to that of the global coordinate system. The y- and the z-direction of the local coordinate system are tilted about this common x-direction depending on an orientation of the component to be described.

The projection exposure apparatus 1 comprises a projection optical unit 10. The projection optical unit 10 serves for imaging the object field 5 into an image field 11 in an image plane 12. The image plane 12 extends parallel to the object plane 6. Alternatively, an angle between the object plane 6 and the image plane 12 that differs from 0° is also possible.

A structure on the reticle 7 is imaged onto a light-sensitive layer of a wafer 13 arranged in the region of the image field 11 in the image plane 12. The wafer 13 is held by a wafer holder 14. The wafer holder 14 is displaceable in particular along the y-direction by means of a wafer displacement drive 15. The displacement, firstly, of the reticle 7 by way of the reticle displacement drive 9 and, secondly, of the wafer 13 by way of the wafer displacement drive 15 can be implemented so as to be synchronized to one another.

The radiation source 3 is an EUV radiation source. The radiation source 3 emits, in particular, EUV radiation 16, which is also referred to below as used radiation or illumination radiation. In particular, the used radiation has a wavelength in the range between 5 nm and 30 nm. The radiation source 3 can be a plasma source, for example an LPP (laser produced plasma) or GDPP (gas discharge produced plasma) source. It can also be a synchrotron-based radiation source. The radiation source 3 can be a free electron laser (FEL).

The illumination radiation 16 emerging from the radiation source 3 is focused by a collector 17. The collector 17 can be a collector with one or with a plurality of ellipsoidal and/or hyperboloid reflection surfaces. The at least one reflection surface of the collector 17 can be impinged upon by illumination radiation 16 with grazing incidence (GI), i.e., at angles of incidence of greater than 45°, or with normal incidence (NI), i.e., at angles of incidence of less than 45°. The collector 17 can be structured and/or coated, firstly, for optimizing its reflectivity for the used radiation and, secondly, for suppressing extraneous light.

The illumination radiation 16 propagates through an intermediate focus in an intermediate focal plane 18 downstream of the collector 17. The intermediate focal plane 18 can represent a separation between a radiation source module, having the radiation source 3 and the collector 17, and the illumination optical unit 4.

The illumination optical unit 4 comprises a deflection mirror 19 and, arranged downstream thereof in the beam path, a first facet mirror 20. The deflection mirror 19 can be a plane deflection mirror or, alternatively, a mirror with a beam-influencing effect going beyond a pure deflection effect. As an alternative or in addition thereto, the mirror 19 can be embodied as a spectral filter separating a used wavelength of the illumination radiation 16 from extraneous light having a wavelength that deviates therefrom. If the first facet mirror 20 is arranged in a plane of the illumination optical unit 4 that is optically conjugate to the object plane 6 as a field plane, said facet mirror is also referred to as a field facet mirror. The first facet mirror 20 comprises a multiplicity of individual first facets 21, which are also referred to as field facets below. Some of these facets 21 are shown in Figure 1 only by way of example.

The first facets 21 can be embodied as macroscopic facets, in particular as rectangular facets or as facets with an arcuate edge contour or an edge contour of part of a circle. The first facets 21 can be embodied as plane facets or, alternatively, as convexly or concavely curved facets.

As is known from DE 10 2008 009 600 A1, for example, the first facets 21 themselves can also each be composed of a multiplicity of individual mirrors, in particular a multiplicity of micromirrors. The first facet mirror 20 can in particular be designed as a microelectromechanical system (MEMS system). For details, reference is made to DE 10 2008 009 600 A1.

The illumination radiation 16 travels horizontally, i.e., along the y-direction, between the collector 17 and the deflection mirror 19.

In the beam path of the illumination optical unit 4, a second facet mirror 22 is arranged downstream of the first facet mirror 20. If the second facet mirror 22 is arranged in or in the vicinity of a pupil plane of the illumination optical unit 4, it is also referred to as a pupil facet mirror. The second facet mirror 22 can also be arranged at a distance from a pupil plane of the illumination optical unit 4. In this case, the combination of the first facet mirror 20 and the second facet mirror 22 is also referred to as a specular reflector. Specular reflectors are known from US 2006/0132747 A1, EP 1 614 008 B1 and US 6,573,978.

The second facet mirror 22 comprises a plurality of second facets 23. In the case of a pupil facet mirror, the second facets 23 are also referred to as pupil facets.

The second facets 23 can likewise be macroscopic facets, which can, for example, have a round, rectangular or hexagonal boundary, or alternatively be facets composed of micromirrors. In this regard, reference is also made to DE 10 2008 009 600 A1.

The second facets 23 can have plane or, alternatively, convexly or concavely curved reflection surfaces.

The illumination optical unit 4 consequently forms a double-faceted system. This basic principle is also referred to as a fly's eye integrator or honeycomb condenser.

It can be advantageous to arrange the second facet mirror 22 not exactly within a plane that is optically conjugate to a pupil plane of the projection optical unit 7.

The individual first facets 21 are imaged into the object field 5 with the aid of the second facet mirror 22. The second facet mirror 22 is the last beam-shaping mirror or, in fact, the last mirror for the illumination radiation 16 in the beam path upstream of the object field 5.

In a further embodiment of the illumination optical unit 4 (not illustrated), a transmission optical unit contributing in particular to the imaging of the first facets 21 into the object field 5 can be arranged in the beam path between the second facet mirror 22 and the object field 5. The transmission optical unit can have exactly one mirror or, alternatively, two or more mirrors, which are arranged in succession in the beam path of the illumination optical unit 4. The transmission optical unit can in particular comprise one or two normal-incidence mirrors (NI mirrors) and/or one or two grazing-incidence mirrors (GI mirrors).

In the embodiment shown in Figure 1, the illumination optical unit 4 has exactly three mirrors downstream of the collector 17, specifically the deflection mirror 19, the field facet mirror 20 and the pupil facet mirror 22.

The deflection mirror 19 can also be dispensed with in a further embodiment of the illumination optical unit 4, and the illumination optical unit 4 can then have exactly two mirrors downstream of the collector 17, specifically the first facet mirror 20 and the second facet mirror 22.

As a rule, the imaging of the first facets 21 into the object plane 6 by means of the second facets 23 or using the second facets 23 and a transmission optical unit is only approximate imaging.

The projection optical unit 10 comprises a plurality of mirrors Mi, which are numbered in accordance with their arrangement in the beam path of the projection exposure apparatus 1.

In the example illustrated in Figure 1, the projection optical unit 10 comprises six mirrors M1 to M6. Alternatives with four, eight, ten, twelve or any other number of mirrors Mi are likewise possible. The penultimate mirror M5 and the last mirror M6 each have a through opening for the illumination radiation 16. The projection optical unit 10 is a double-obscured optical unit. The projection optical unit 10 has an image-side numerical aperture that is greater than 0.5 and can also be greater than 0.6 and, for example, be 0.7 or 0.75.

Reflection surfaces of the mirrors Mi can be embodied as free-form surfaces without an axis of rotational symmetry. Alternatively, the reflection surfaces of the mirrors Mi can be designed as aspherical surfaces with exactly one axis of rotational symmetry of the reflection surface form. Just like the mirrors of the illumination optical unit 4, the mirrors Mi can have highly reflective coatings for the illumination radiation 16. These coatings can be designed as multilayer coatings, in particular with alternating layers of molybdenum and silicon.

The projection optical unit 10 has a large object-image offset in the y-direction between a y-coordinate of a centre of the object field 5 and a y-coordinate of the centre of the image field 11. In the y-direction, said object-image offset can be approximately the same size as a z-distance between the object plane 6 and the image plane 12.

In particular, the projection optical unit 10 can have an anamorphic design. In particular, it has different imaging scales $\beta_x$, $\beta_y$ in the x- and y-directions. The two imaging scales $B_x$, $\beta_y$ of the projection optical unit 7 preferably lie at $(B_x, \beta_y)$ = (+/- 0.25, +/- 0.125). A positive imaging scale $\beta$ means imaging without image erection. A negative sign for the imaging scale $\beta$ means imaging with image erection.

Consequently, the projection optical unit 7 leads to a reduction with a ratio of 4:1 in the x-direction, i.e., in a direction perpendicular to the scanning direction.

The projection optical unit 10 leads to a reduction of 8:1 in the y-direction, i.e., in the scanning direction.

Other imaging scales are likewise possible. Imaging scales with the same sign and the same absolute value in the x- and y-directions are also possible, for example with absolute values of 0.125 or 0.25.

The number of intermediate image planes in the x- and in the y-direction in the beam path between the object field 5 and the image field 11 can be the same or, depending on the embodiment of the projection optical unit 10, can be different. Examples of projection optical units with different numbers of such intermediate images in the x- and y-directions are known from US 2018/0074303 A1.

In each case one of the pupil facets 23 is assigned to exactly one of the field facets 21 for forming in each case an illumination channel for illuminating the object field 5. In particular, this can produce illumination according to the Köhler principle. An illumination region of an arrangement plane of the field facets 21, which is also referred to as the far field, is decomposed into a multiplicity of object fields 5 with the aid of the field facets 21. The field facets 21 produce a plurality of images of the intermediate focus on the pupil facets 23 respectively assigned thereto.

The field facets 21 are imaged, in each case by way of an assigned pupil facet 23, onto the reticle 7 in a manner such that they are overlaid on one another for the purposes of illuminating the object field 5. The illumination of the object field 5 is in particular as homogeneous as possible. It preferably has a uniformity error of less than 2%. Field uniformity can be attained by overlaying different illumination channels.

The illumination of the entrance pupil of the projection optical unit 10 can be geometrically defined by an arrangement of the pupil facets. The intensity distribution in the entrance pupil of the projection optical unit 10 can be set by selecting the illumination channels, in particular the subset of pupil facets, which guide light. This intensity distribution is also referred to as illumination setting.

A likewise preferred pupil uniformity in the region of sections of an illumination pupil of the illumination optical unit 4 that are illuminated in a defined manner can be achieved by a redistribution of the illumination channels.

Further aspects and details of the illumination of the object field 5 and, in particular, of the entrance pupil of the projection optical unit 10 are described below.

In particular, the projection optical unit 10 can comprise a homocentric entrance pupil. The latter can be accessible. It can also be inaccessible.

The entrance pupil of the projection optical unit 10 cannot be illuminated regularly with the pupil facet mirror 22 in an exact manner. In the case of imaging the projection optical unit 10 in which the centre of the pupil facet mirror 22 is telecentrically imaged onto the wafer 13, the aperture rays often do not intersect at a single point. However, it is possible to find a surface in which the spacing of the aperture rays, determined in pairwise fashion, is minimal. This area represents the entrance pupil or an area in real space that is conjugate thereto. In particular, this area has a finite curvature.

The projection optical unit 10 might have different positions of the entrance pupil for the tangential beam path and for the sagittal beam path. In this case, an imaging element, in particular an optical component of the transmission optical unit, should be provided between the second facet mirror 22 and the reticle 7. With the aid of said optical element, the different positions of the tangential entrance pupil and the sagittal entrance pupil can be taken into account.

In the arrangement of the components of the illumination optical unit 4 illustrated in Figure 1, the pupil facet mirror 22 is arranged in a surface conjugate to the entrance pupil of the projection optical unit 10. The field facet mirror 20 is arranged so as to be tilted with respect to the object plane 5. The first facet mirror 20 is arranged so as to be tilted with respect to an arrangement plane defined by the deflection mirror 19.

The first facet mirror 20 is arranged so as to be tilted with respect to an arrangement plane defined by the second facet mirror 22.

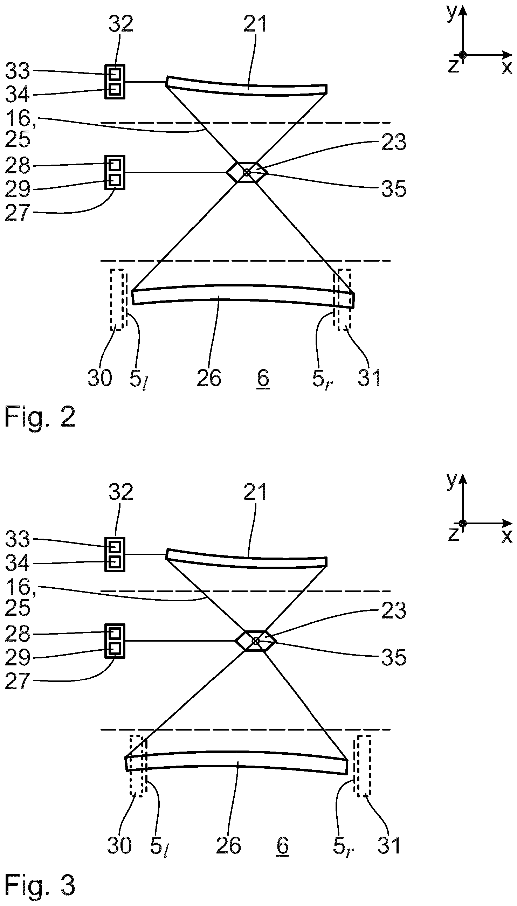

Figure 2 schematically shows a section of an illumination channel 25 of the illumination optical unit 4, which is also referred to as an illumination channel. A schematic beam path of the illumination channel 25 is illustrated between one of the field facets 21 of the field facet mirror 20 and an image 26 of this field facet 21 in the object plane 6. The illumination channel 25 is specified by way of the field facet 21 and the associated pupil facet 23 of the pupil facet mirror 22 of the illumination optical unit 4. In the embodiment illustrated in Figure 2, the field facet 21 is illustrated with an arcuate edge of its reflection surface and the pupil facet 23 is illustrated with a hexagonal edge of its reflection surface. Other edge shapes of the field facets 21 are also possible, for example rectangles. An x/y-aspect ratio of the field facets 21 is in the region of 10:1, but it can also adopt other values ranging between 1:2 and 1:20, for example. The pupil facets 23 can also have different edge shapes for their reflection surfaces, for example circles, rectangles or squares.

The illumination light 16 is guided via the field facet 21 and the pupil facet 23 to the object field in the object plane 6 of the projection exposure apparatus 1, not illustrated in Figure 2, by means of the illumination channel 25. The field facet images 26 generated by way of the various illumination channels 25 assigned to the various facets 21, 23, are imaged, in a manner overlaid on one another, into the object field via the pupil facets 23 of the pupil facet mirror 21.

The field facets 21 are embodied to be switchable between different tilt positions such that illumination channels 25 with a plurality of different pupil facets 23 that are selectable by way of the respective switching position of the field facet 21 can be specified by way of one and the same field facet 21. This can be used to specify various illumination settings.

The pupil facets 23 each have a tiltable embodiment. Each of the tiltable pupil facets 23 interacts with a tilt actuator system 27, which is illustrated schematically in Figure 2.

This tilt actuator system 27 of the pupil facet 23 or the pupil facet mirror 22 has a coarse actuator system or a coarse actuator system mode of operation 28 for specifying a coarse tilt angle of the tiltable pupil facet 23. This coarse tilt angle is the result of an illumination channel assignment of the tiltable pupil facet 23 to the field facet 21 and ensures the overlaid imaging of the field facet images 26 in the object field 5.

Furthermore, the tilt actuator system 27 comprises a fine actuator system or a fine actuator system mode of operation 29 for specifying a fine tilt angle of the tiltable pupil facet 23. The fine tilt angle serves to specify a precise relative position of the field facet image 26 of the illumination channel 25 of the tiltable pupil facet 23 relative to the object field and thus facilitates a fine displacement of the field facet image 26 in the object plane 6.

The image 26 of the field facet 21 in the object plane 6 is regularly smaller than the object field 5 in the scan direction y. A fine displacement of the image 26 of the field facet 21 in the y-direction therefore typically leads to the image 26 still lying within the object field 5 in the y-direction. The image 26 of the field facet 21 in the object plane 6 is regularly larger than the object field 5 orthogonal to the scan direction y, i.e., along the x-coordinate. What suitable stops in or in front of the projection optical unit 10 achieve is that the region of the object plane 6 which is imaged into the image plane 12 is restricted to the width of the object field 5 or the width of the image field 11 in the x-direction. A fine displacement of the image 26 of the field facet 21 in the x-direction therefore typically leads to the image still illuminating the entire object field 5 in the x-direction. Thus, fine displacements of the image 26 of the field facet 21 change the illumination of the object field 5 without changing the fact of the illumination as such. This can be used according to the invention as described below.

The coarse actuator system 28 can be realized by means of actuators respectively assigned to the pupil facets 23, said actuators interacting with stops for specifying a respective coarse tilt position. In this case, use can be made of actuators which are already known from the prior art in the context of switchable field facets.

The fine actuator system 29 of the respective pupil facet 23 can be realized by way of piezo-actuators, in particular piezo-stacks. Such piezo-actuators are also known from the prior art.

As an alternative to realizing, firstly, the coarse actuator system 28 and, secondly, the fine actuator system 29 by way of separate actuators, a coarse actuator system and a fine actuator system of the tilt actuator system 27 can also be realized by, firstly, a coarse actuator system mode of operation and, secondly, a fine actuator system mode of operation of one and the same actuator system.

A tilt of the respective pupil facet 23, firstly about an axis parallel to the x-axis and secondly about an axis parallel to the y-axis, is possible by way of the fine actuator system. Additionally, a displacement of the respective pupil facet 23 along the z-direction can be facilitated by way of the coarse actuator system 28 and/or the fine actuator system 29.

A maximum coarse tilt angle range specifiable by the coarse actuator system 28 can be greater than a maximum fine tilt angle range specifiable by the fine actuator system 29 by at least a factor of 10.

In principle, all pupil facets 23 of the pupil facet mirrors 22 can have a tiltable design in the style of the pupil facet 23 described above in conjunction with Figure 2. A plurality of types of pupil facets 23 are present in alternative embodiments of the pupil facet mirror 22, specifically pupil facets 23 which have a tilt actuator system 27 in the style of the pupil facet 23 illustrated in Figure 2 and at least one further type of pupil facet with a simpler variant of the tilt actuator system or without any tilt actuator system.

An illumination light intensity can vary over the field facet image 26 and can have different values, in each case integrated over the respective y-coordinate of the field facet image 26, for example depending on the x-dimension. By way of example, the illumination channel 25 in the section of the field facet image 26 on the right in Figure 2 can carry less intensity than in the mid and left section in Figure 2.

Figure 2 furthermore shows two energy sensors 30, 31 which are arranged separately from one another and which measure illumination energy of the illumination light 16 in the object plane 6 at two sensor locations, the object field 5 being arranged therebetween. A left edge $5_l$ and a right edge $5_r$ of the object field arranged between the two energy sensors 30, 31 are schematically indicated in Figure 2.

It is also possible to provide a greater number of such energy sensors around the object field 5. In particular, the energy sensors can facilitate a spatially resolved energy measurement around the object field, wherein use can be made of more than two energy sensors, for example four energy sensors, five energy sensors, eight energy sensors, ten energy sensors or even more of such energy sensors.

Each of the switchable field facets 21 has a tilt actuator system 32 which, in addition to a switch actuator system 33 for specifying the respective switch position, comprises a fine tilt actuator system 34 corresponding to the fine actuator system 29 of the tiltable pupil facets 23. The fine tilt actuator system 34 of the respective field facet 21 serves to specify a fine tilt angle of the field facet 21 for the purposes of specifying a relative position of the illumination channel 25 relative to the pupil facet 23 assigned to the field facet 21 by way of this illumination channel 25.

A tilt of the respective field facet 21, firstly about an axis parallel to the x-axis and secondly about an axis parallel to the y-axis, is possible by way of the fine tilt actuator system 34. Additionally, a displacement of the field facet 21 along the z-direction can be facilitated by way of the fine actuator system 34.

The guidance of the illumination channel 25 by the respective field facet 21 can be such that a source image 35 of the light source or radiation source 3 is located in the vicinity of an impingement location of the pupil facet 23 of the illumination channel 25.

In the current setting illustrated in Figure 2, the fine tilt actuator system 34 of the field facets 21 is set such that the source image 35 is located centrally on the pupil facet 23. The fine actuator system 29 of the pupil facet 23 is set in turn such that the right section of the field facet image 26 completely covers the energy sensor 31 to the right in Figure 2, and so the energy sensor 31 stably measures a measure for the energy transported in the illumination channel 25. A right edge of the field facet image 26 in Figure 2 in this case is located beyond the energy sensor 31 so that slight jitter movements of the field facet image 26 or slight drifts in the field facet image 26 do not lead to the right section of the field facet image 26 in Figure 2 only still incompletely covering the energy sensor 31.

Typically, there is a systematic intensity profile of the illumination light 16 across the width (x-direction) of the respective field facet 21, said intensity profile being different for different field facets 21. This also applies accordingly to the intensity profile of the field facet image 26. If the intensity of the field facet image 26 is lower at the right edge than the mean over the entire field facet image, the right energy sensor 31 systematically underestimates the contribution of the field facet 20 to the illumination of the object field 5. Analogously, the contribution of the field facet 20 can also be systematically overestimated by the right energy sensor 31 in the case of an opposite intensity profile.

Figure 3 likewise shows the illumination channel 25 according to Figure 2 with the associated components in an illustration similar to Figure 2. In contrast to Figure 2, the fine actuator system 29 of the pupil facet mirror 22 has been adjusted in the current setting according to Figure 3 so that the field facet image 26 has been displaced to the left energy sensor 30 in Fig-ure 3 in the negative x-direction of Figure 3. While only the right energy sensor 31 of Figure 2 is impinged by the field facet image 26 in the current setting according to Figure 2, only the left energy sensor 30 of Figure 3, i.e., the other of the two energy sensors 30, 31, is impinged by the field facet image 26 in the current setting according to Figure 3. To this end, the pupil facet 23 is tilted about an axis parallel to the y-axis by way of the fine actuator system 29.

This fine actuator-based adjustment of the pupil facet 23 can be used in a method for setting or adjusting the facet mirrors 20, 22 of the illumination optical unit 4 of the illumination system 2. In this case, the illumination channels 25 of the illumination optical unit 4 which should impinge a first of the two energy sensors 30, 31, for example the energy sensor 30, are specified in an initial step. Furthermore, those illumination channels 25 which should impinge a second of the two energy sensors 30, 31, for example the energy sensor 31, are specified. In an alternative configuration of this adjustment method, numbers of the illumination channels 25 of the illumination optical unit which should respectively impinge the first energy sensor, i.e., for example the left energy sensor 30, and respectively impinge the second energy sensor, i.e., for example the right energy sensor 31, can be specified. Subsequently, the respective fine actuator system 29 of the tilt actuator systems 27 of the pupil facets 23 which are assigned to the respective illumination channels 25 is set such that the specified energy sensors 30, 31 are impinged by the illumination channels 25.

By way of example, this makes it possible to ensure that, given a specified illumination setting, a desired energy distribution of an illumination of the object field from different directions is observed without unwanted systematic errors arising.

If there is an intensity gradient across the field facet image 26, one of the two energy sensors 30, 31 will systematically underestimate the contribution of the field facet 21 to the illumination of the object field 5 while the other will systematically overestimate the contribution. As a result of the described fine control, it is possible to switch between the two energy sensors 30, 31 in such a way that these systematic effects of the individual illumination channels are cancelled when averaged over the field facet mirror 20.

Particularly if an illumination light intensity within the field facet image 26 near the left energy sensor 30 in Figure 2 deviates from the intensity near the right energy sensor 31 in Figure 2, for example on account of an intensity gradient within the illumination of the field facets 21, the energy sensor 30 or 31 which is suitable in respect of its sensitivity can be selected for such an illumination channel 25 by specifying the fine tilt angle. As a result of this, it is possible in particular to reduce a far field tilt sensitivity of the illumination optical unit 4 in respect of a dose measured by the energy sensors 30, 31, leading to a stabilisation of the illumination optical unit 4 in the case of such a far field tilt.

An assignment of the energy sensors 30 and 31, which are impinged via the illumination channels 25 of the respective pupil facets 23, can be adapted on the basis of the respective illumination setting and can also be adapted on the basis of, for example, a change in a far field intensity profile ascertained by calibration measurement or simulation. Such an adaptation can be implemented within the scope of an automated method.

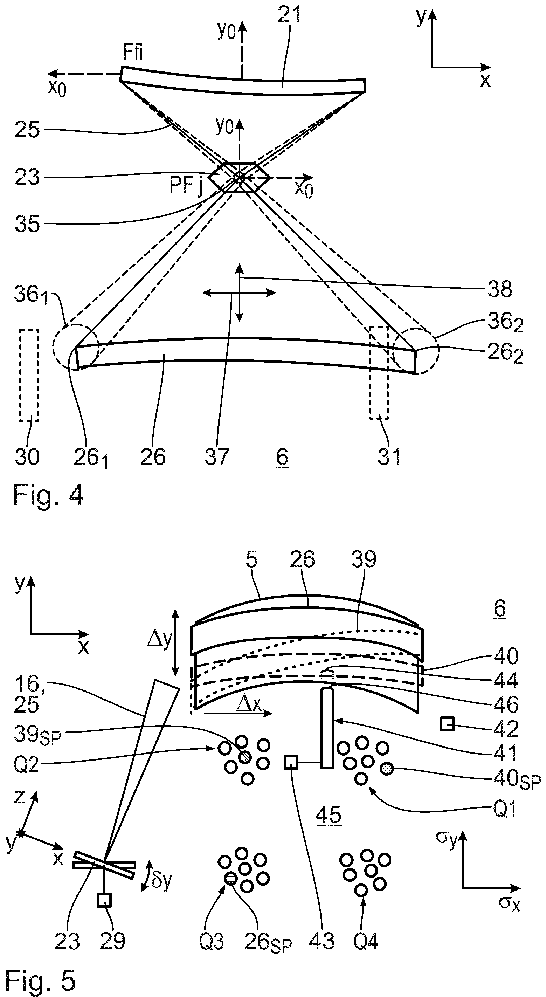

Figure 4 shows the effect of relative mechanical position tolerances, firstly, of the field facet 21 and, secondly, of the pupil facet 23 of the associated illumination channel 25 on a relative position of the field facet image 26 in an representation which is firstly schematic and secondly exaggerated in terms of the tolerances. Components and functions corresponding to those which were already explained above with reference to Figures 2 and 3 have the same reference signs and are not discussed in detail again.

The effect of corresponding manufacturing tolerances is illustrated in Fig-ure 4 on the basis of possible target positions on account of these manufacturing tolerances, firstly of a top left corner $26_1$ and secondly of a top right corner $26_2$

of the field facet image 26. On account of the mechanical tolerances, these corners $26_1$, $26_2$ could be located within a region which is schematically indicated in each case by way of a circular tolerance line $36_1$, $36_2$. By specifying corresponding fine tilt angles by way of the fine actuator system 29 of the pupil facet 23 on the one hand and the fine tilt actuator system 34 of the field facet 21 on the other hand, it is possible to compensate these tolerances in accordance with the tolerance lines $36_1$, $36_2$. With the aid of a closed-loop position control, which facilitates an accurate determination of the relative position of the respective field facet image 26, for example relative to the two energy sensors 30, 31, it is possible to specify travels for adjustment movements 37 in the x-direction and 38 in the y-direction such that the corners $26_1$ and $26_2$ come to rest in the centre of the respective tolerance lines $36_1$, $36_2$ after an adjustment has been implemented, as visualized in Figure 4. A positioning of the respective source image 35 on the pupil facet 23 can also be optimized in this way.

In Figure 4, tilt axes $x_0$, $y_0$ for the actuator-based tilt are indicated firstly for the field facet 21 and secondly for the pupil facet 23.

In this way, it is possible in particular to ensure exact and reproducible positioning of the respective field facet image 26 relative to the relative position of the energy sensors 30, 31, improving the stability and reproducibility of the measurement by way of the energy sensors 30, 31.

Figure 5 shows, once again schematically, the effects of an adjustment of the fine actuator system 29 of the associated pupil facet 23 on the relative position of a respective field facet image 26 in the object field 5. Components and functions corresponding to those which were already explained above with reference to Figures 1 to 4 are denoted by the same reference signs and are not discussed in detail again.

Figure 5 illustrates not only the relative position in the object field 5 of the field facet image 26 which belongs to the illumination channel 25 of the illustrated pupil facet 23, but also the relative position of further field facet images 39 and 40 which belong to other illumination channels 25 and accordingly to other pupil facets 23 not illustrated here.

The field facet images 26, 39, 40 are all arcuate, i.e., have a similar shape to one another. The field facet images 26, 39, 40 differ from one another in respect of the arc orientation and in respect of their x-extent and, not evident from Figure 5, also in respect of their y-extent.

These orientation and/or size differences emerge firstly from different imaging effects of the field facets 21 and pupil facets 23 which are assigned to the respective illumination channels 25 and secondly also from the different spatial profiles of the respective illumination channels 25 on their path from the respective field facets 21 to the respective field facet image 26, 39 and 40. A corresponding different orientation can also arise from a different x-offset of the respective position specification of one of the field facet images 26, 39, 40 by way of the specification of the fine tilt angle.

The illustrated pupil facet 23 is shown with two exaggerated tilt positions, which differ by a tilt angle $\delta y$. The tilt of the pupil facet 23 through the tilt angle $\delta y$ leads to a displacement of a relative y-position of the field facet image 26 relative to the object field 5, as illustrated in Figure 5 by a double-headed arrow $\Delta y$.

A tilt of the pupil facet 23 about a tilt axis $\delta x$ lying in the plane of the drawing of Figure 5, which is possible as an alternative or in addition thereto, accordingly leads to a displacement of the field facet image 26 in the x-direction.

Furthermore, Figure 5 illustrates a shadowing finger 41 of a field intensity specification device 42 that is otherwise illustrated schematically. The latter is arranged in the region of the field plane of the projection exposure apparatus 1, for example in the region of the object plane 6. In fact, the field intensity specification device 42 comprises a plurality of shadowing fingers 41, only one of which is illustrated in Figure 5. The shadowing fingers 41 have a longitudinal extent in the y-direction and are displaceable independently of one another by way of an actuator in the y-direction by means of a displacement actuator system 43. As a result of this displacement in the y-direction, the shadowing fingers 41 can be inserted into the illumination channels 25, specifically into the field facet images 26, 39, 40, from the side, for example from below in Figure 5. In this way, it is optionally possible to partly shadow the field facet images 26, 39, 40 closest to the respective shadowing finger 41 and hence the associated illumination channels 25. This shadowing acts individually at the location of the respective shadowing finger 41, i.e., in the region of the respective x-field coordinate. Corresponding field intensity specification devices 42 are known from the prior art.

For a given shadowing finger 41, a relative position relation of the field facet image positions in the region of the x-coordinate of this shadowing finger 41 can be influenced by way of the fine actuator systems 29 of the pupil facets 23 assigned to the field facet images 26, 39, 40 by way of the respective illumination channels 25. By way of example, this relative position relation can be chosen in such a way that all edge regions of the field facet images 26, 39, 40 facing the shadowing finger 41 are overlaid on one another in the region of the x-field coordinate of the shadowing finger 41.

To this end and according to Figure 5, proceeding from the relative position of the field facet images 26, 39, 40, the field facet image 26 must be displaced by a longer path in the negative y-direction than the field facet image 39 so that an edge region overlay at the location of an edge region 44 of the field facet image 40 is obtained. If the shadowing finger 41 is then inserted into the object field 5 in the positive y-direction, it simultaneously shadows all three field facet images 26, 39, 40 in the edge region 44. This leads to the illumination channels 25 assigned to these field facet images 26, 39, 40 being shadowed in the same way, reducing the illumination intensity from the direction of these illumination channels 25 in the same way.

This is visualized using the example of a quadrupole illumination setting, likewise in Figure 5. This quadrupole illumination setting is illustrated in a pupil plane 45 of the projection optical unit 10, which is spaced apart from the object plane 6 along the beam path of the illumination radiation 16, which is therefore shown purely schematically in the plane of the drawing in Figure 5.

The quadrupole illumination setting has four individual poles Q1, Q2, Q3 and Q4, which in turn are subdivided into sub-pupil regions which are arranged in the form of a hexagonal grid in the illustrated embodiment.

Sub-pupil regions $26_{SP}$, $39_{SP}$ and $40_{SP}$, which are assigned to the illumination channels 25 of the field facet images 26, 39, 40, are emphasized by circles in this quadrupole setting.

The sub-pupil region $26_{SP}$ is located at the left lower edge of the pole Q3. The sub-pupil region $39_{SP}$ is located in the mid section of the pole Q2. The sub-pupil region $40_{SP}$ is located in the lower right section of the pole Q1. In the aforementioned alignment of the three field facet images 26, 39, 40 such that these overlap in the edge region 44, there is uniform shadowing of the illumination from the direction of the three sub-pupil regions $26_{SP}$, $39_{SP}$ and $40_{SP}$ in this edge region 44 when the shadowing finger 41 is inserted. Accordingly, it is also possible to achieve overlays of other desired combinations of field facet images assigned to the illumination channels 25 by way of respective fine actuator-based adjustment of the pupil facets 23 and, accordingly, the displacement of the field facet images in the x- and/or y-direction.

In this way, it is possible for example to achieve a point-symmetric effect of shadowing of the illumination channels 25 in the pupil of the illumination optical unit 10.

As an alternative or in addition thereto, it is possible to initially specify a relative position of the respective shadowing finger 41 of the field intensity specification device 42 and it is then possible, for example on the basis of measurement or simulation results, to specify a displacement of the respective field facet images relative to this initially specified relative position of the shadowing finger 41 such that this yields a desired shadowing effect in the associated x-field coordinate, as seen over the illumination setting.

An unwanted distribution of an intensity reduction between different illumination channels 25 during the shadowing finger correction, which is also referred to as crosstalk, for example a pronounced telecentricity deviation (y-axis asymmetry), can then be reduced or entirely avoided.

In particular, use can be made of the following method for adjusting at least one of the facet mirrors 20, 22, in particular for adjusting the pupil facet mirror 22:

Initially, the position of the shadowing finger 41 of the field intensity specification device 42 is selected and specified by way of the displacement actuator system 43. Then, at least one illumination channel 25 is selected and the fine actuator system 29 of the tilt actuator system of the associated pupil facet 23 is set such that a specified relative position is reached between a free end 46 of the shadowing finger 41 and an edge (edge region 44) of the illumination channel 25 facing this free end.

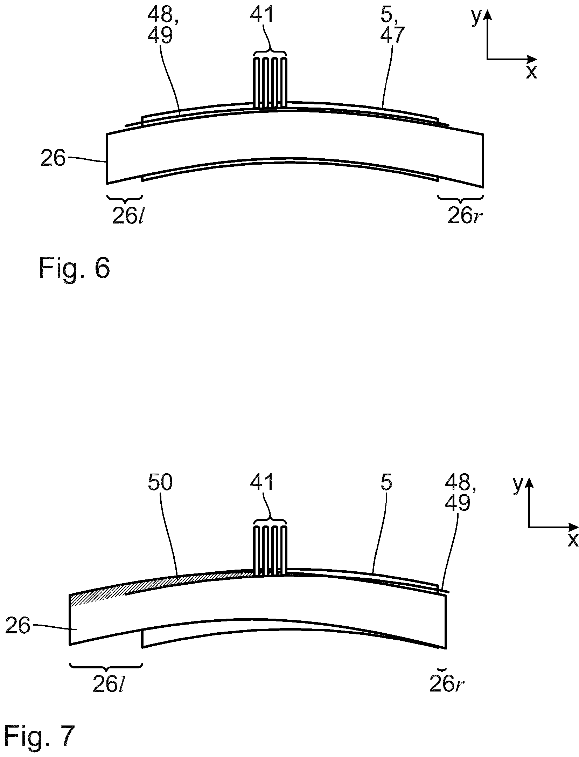

In this adjustment method, it is possible in particular to also use the displacement of the field facet images, for example the field facet image 26, in the x-direction. This is elucidated in greater detail below with reference to Figures 6 and 7:

In turn, Figure 6 shows the field facet image 26 in an initial relative position relative to the object field 5, which is specified by way of a scanning slot stop 47. Moreover, an upper edge boundary 48 of a field stop 49 which is a constituent part of the field intensity specification device 42 is indicated in Figure 6.

The edge boundary 48 can be formed by a plurality of free ends of shadowing fingers in the style of the free ends 46 of the shadowing finger 41 which were explained above in conjunction with Figure 5 and which are inserted into the object field 5 from above at the various x-field coordinates in Figure 6. In Figure 6, these shadowing fingers 41 are indicated for a section of the field stop 49. An x-extent of the field facet image 26 is greater on both sides of the object field 5 than an x-extent of the object field 5. Corresponding x-protrusion regions $26_l$ to the left of the object field 5 in Figure 6 and $26_r$ to the right of the object field 5 in Figure 6 can be used firstly for impinging energy sensors in the style of the energy sensors 30, 31 of Figures 2 to 4 but secondly also yield an x-displacement degree of freedom of the field facet image 26 relative to the object field 5.

Figure 7 shows, in an illustration otherwise corresponding to Figure 6, the relative position of the field facet image 26 after a fine actuator-based tilt of the associated pupil facet 23 about an axis parallel to the y-axis. This fine-actuator based tilt leads to displacement of the field facet image 26 relative to the object field 5 in the negative x-direction. On account of the x-extent of the field facet image 26 being significantly greater than the x-extent of the object field 5, the field facet image 26 still covers the entire x-extent of the object field 5. On account of the arcuate form of the field facet image 26 there is approximately sickle-section-shaped shadowing 50 of the field facet image 26 by the field stop 49 since the relative position of the edge boundary 48 of the field stop 49 of the field intensity specification device 42 is unchanged in comparison with Figure 6. This shadowing acts approximately over a complete left half of the x-extent of the object field 5 and increases toward the left side, i.e., toward the left edge section $26_l$, from the centre of the object field 5. Field-dependent shadowing of the associated illumination channel arises in respect of the edge boundary of the field facet image 26. To the extent that the field facet image 26 is illuminated with a homogeneous intensity distribution by the illumination light 16, greater shadowing from the direction of this illumination channel 25 arises for small x-coordinates of the object field 5 (left region of the object field 5) than for larger x-coordinates.

As a result of an additional tilt of the pupil facet 22 about an axis parallel to the x-axis, the field facet image 26 can be moved further in the direction of the field stop 49 of the field intensity specification device 42 in the y-direction such that the field facet image is shadowed by the field stop at each x-coordinate. A change in the tilt of the pupil facet 22 about an axis parallel to the y-axis, i.e., a displacement of the field facet image 26 in the x-direction, then leads to a change in the shadowing by the field stop 49, which is approximately linear with the x-coordinate. Hence, a change in the tilt of the pupil facet 22 about an axis parallel to the y-axis leads to a change in the scan-integrated illumination of the object field, with the change being approximately linear to the x-coordinate. In contrast to a single lone application of the field intensity specification device 42, this can specify a different intensity change profile for each illumination channel $25_k$ (and hence for the associated region in the illumination pupil).

The x-coordinate-dependent shadowing 50 of the field facet image 26, which is attained by the x-displacement of the arcuate field facet image 26, can be used for desired field dependencies of an angle-dependent illumination intensity distribution of the respective illumination setting. As an alternative or in addition thereto, other inhomogeneities in such a field distribution present can be corrected and/or compensated by field dependencies introduced in such targeted fashion. When setting the fine actuator system 29, which is explained above with reference to Figures 6 and 7, the associated pupil facet 22 is tilted about a y-axis, i.e., about an axis which is arranged parallel to the longitudinal axis of the respective shadowing fingers 41. Accordingly, a displacement of the field facet image 26 perpendicular to this longitudinal axis arises.

The effect of the coarse actuator system 28 of the tilt actuator system 27 of the pupil facets 23 on the one hand and the switching actuator system 33 of the field facets 21 on the other hand is explained below on the basis of Fig-ures 8 to 13. In particular, the tilt actuator system 27 can be used to optimize a pupil fill ratio or a NILS value.

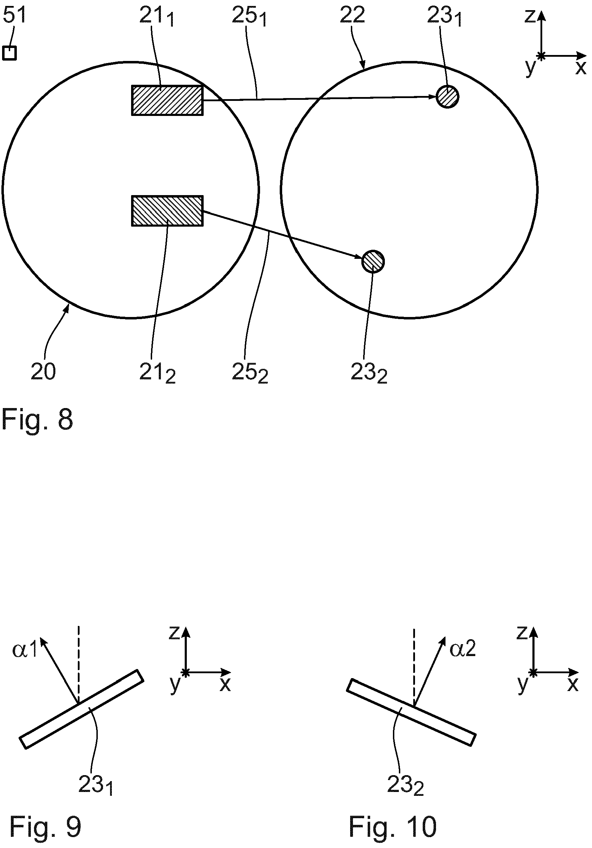

Figure 8 schematically shows the field facet mirror 20 and the pupil facet mirror 22 of the illumination optical unit 4. Two illumination channels $25_1$, $25_2$ with field facets $21_1$, $21_2$ and pupil facets $23_1$ and $23_2$ assigned thereto are emphasized. In the switch configuration of the field facets $21_1$ and $21_2$ according to Figure 8, the pupil facet $23_1$ is assigned to the field facet $21_1$ via the illumination channel $25_1$ and the pupil facet $23_2$ is assigned to the field facet $21_2$ via the illumination channel $25_2$. Angles of incidence $\alpha1$, $\alpha2$ of chief rays of the illumination light 16 on the pupil facets $23_1$ and $23_2$ in the switch configuration according to Figure 8 are visualized in Figures 9 and 10.

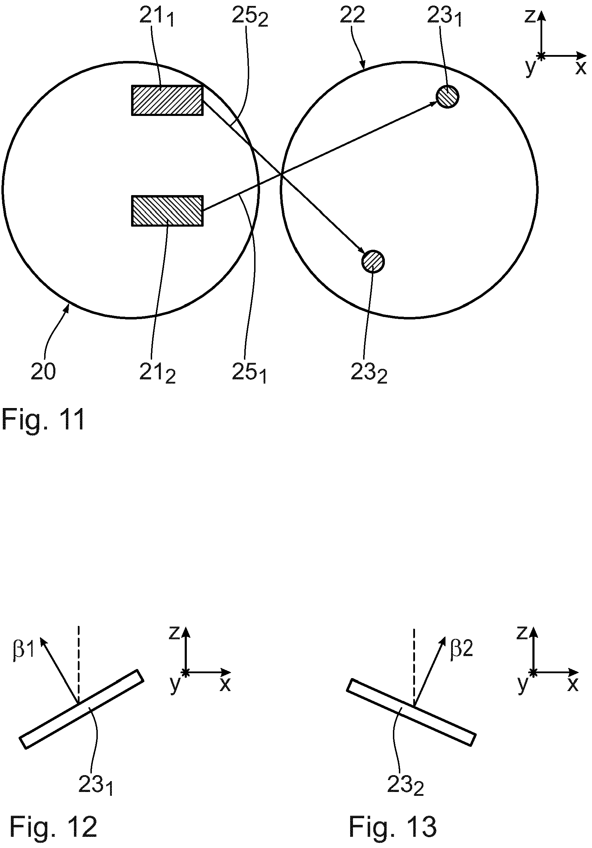

Figure 11 shows an alternative switch configuration of the field facets $21_1$, $21_2$, which was obtained by switching these two field facets $21_1$, $21_2$ by means of the switching actuator system 33. Now, the pupil facet $23_1$ is assigned to the field facet $21_2$ via the illumination channel $25_1$ and the pupil facet $23_2$ is assigned to the field facet $21_1$ via the illumination channel $25_2$. Thus, in comparison with Figure 8, there has been a change in the assignment of the pupil facets $23_1$, $23_2$ to the field facets $21_1$, $21_2$. The two field facets $21_1$, $21_2$ have accordingly switched between the pupil facets $23_1$, $23_2$.

Figures 12 and 13 elucidate the angles of incidence $\beta1$, $\beta2$ on the pupil facets $23_1$, $23_2$ in the switch configuration according to Figure 11. These angles of incidence $\beta1$, $\beta2$ and, in particular, reflected directions of the illumination light 16 differ in the case of the respective pupil facets $23_1$, $23_2$ when the two switch configurations according to Figures 8 and 11 are compared. So that the field facet images respectively assigned to the illumination channels $25_1$, $25_2$ are overlaid as desired in the object field 5, it is therefore necessary to tilt the pupil facets $23_1$, $23_2$ in order to bring about the desired reflected direction of the illumination light 16. This tilt is implemented by means of the coarse actuator system 28 of the pupil facets $23_1$, $23_2$.

The change in the assignment of the field facets $21_1$, $21_2$ to the pupil facets $23_1$, $23_2$ can be used, for example, when different integrated illumination light intensity levels are transported via the field facets $21_1$, $21_2$ on account of a corresponding far field distribution of the illumination light over the field facet mirror 20. By way of example, should the field facet $21_2$ be impinged with a higher intensity level than the field facet $21_1$ in the impingement situation of the field facet mirror 20 according to Figure 8 and if this intensity ratio is precisely inverted in the impingement situation of the field facet mirror 20 according to Figure 11, this inversion of the intensity impingement can be exactly compensated by the assignment change on account of the different switch configurations of Figures 8 and 11.

The illumination system 2 can comprise a far field sensor 51, illustrated schematically in Figure 8, for a spatially resolved far field measurement of an illumination intensity level of the radiation source or light source 3 of the illumination system 2. The far field sensor 51 can be configured as a plurality of energy sensors which, for example, are attached around the field facet mirror 20. As an alternative or in addition thereto, individual sensors of the far field sensor 51 can be housed in sections of the field facet mirror 20 not used in terms of occupancy by field facets 21. A far field measurement over a further alternative embodiment of the far field sensor 51 can be implemented, for example, by way of a thermal imaging camera which captures the entire field facet mirror 20 impinged by the illumination light 16.

In the case of a facet mirror adjustment method using such a far field sensor 51, a far field of the light source 3 of the illumination system 2 is initially measured in spatially resolved fashion by the far field sensor 51. This measurement can be implemented at the location of the field facet mirror 20, although this is not mandatory. Subsequently, an illumination channel assignment of firstly the field facets 21 and secondly the pupil facets 23 assigned thereto via the respective illumination channels 25 is undertaken, in such a way that a specified intensity illumination of the object field 5 from the direction of the pupil facets 23 arises when the far field measurement result is used as a basis. Finally, the field facets 21 switched by the switch actuator system 33 and the coarse actuator system 28 of the tilt actuator system 27 of the pupil facets 23 are set in such a way that the selected illumination channel assignment arises. To finely adjust the relative illumination channel positions, it is possible also to use the fine actuator system 29 of the tilt actuator system 27 and the fine tilt actuator system 34, as explained in exemplary fashion above. Beyond a simple pairwise change of two relative illumination channel positions, an adjustment of a plurality of relative illumination channel positions can also be attained accordingly for the purposes of improving selected illumination parameters.

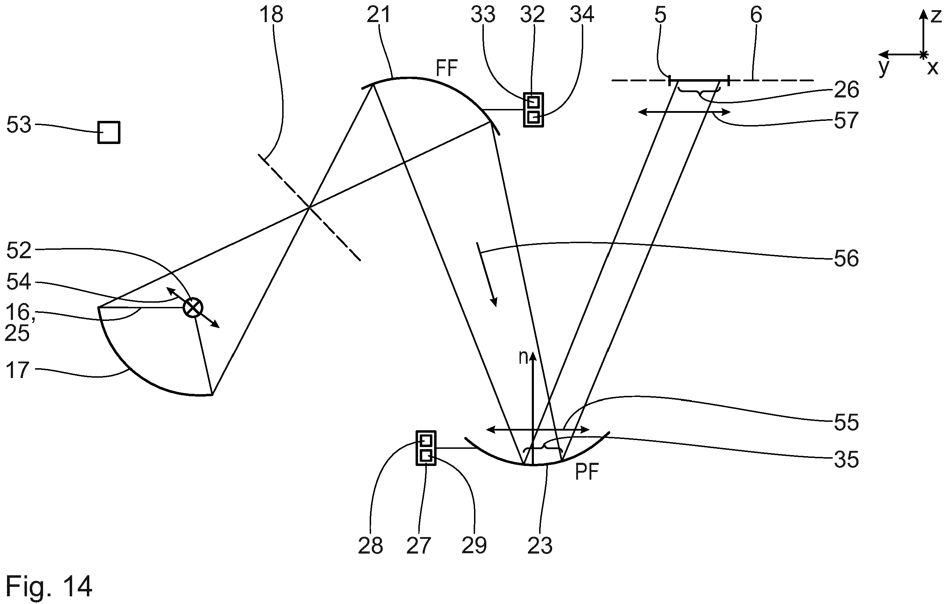

Figure 14 shows a further application of the actuator-based displacement of the field facets 21 on one hand and the pupil facets 23 on the other hand. Component parts and functions which were already explained above on the basis of Figures 1 to 13 have the same reference signs and are not discussed again in detail.

Figure 14 schematically shows the beam path of an illumination channel 25 between a source volume 52, for example a plasma volume, and the object field 5. The EUV radiation 16 emanating from the source volume 52 is initially collected by the collector 17, which is a collector mirror with an ellipsoid shape in the embodiment according to Figure 14.

Figure 14 illustrates the field facet 21 of the field facet mirror 20 assigned to the illumination channel 25 and the pupil facet 23 of the pupil facet mirror 22 assigned to the illumination channel 25 in exaggerated fashion.

In the embodiment according to Figure 14, the illumination system 2 furthermore comprises a relative source position sensor 53 for determining a relative spatial position of the source volume 52 relative to the collector 17.

In particular, the relative source position sensor 53 captures jitter movements and/or drift movements of the source volume 52, visualized in Fig-ure 14 by a double-headed arrow 54. These movements 54 of the source volume 52 lead to a corresponding displacement of the source image 35 on the pupil facet 23, which is visualized in Figure 14 by a double-headed arrow 55.

The displacement of the source image 35 on the pupil facet 23 leads to a change in direction of the chief ray 56 of the illumination light 16, which is guided in the illumination channel 25, relative to a normal n on the reflection surface of the pupil facet 23 in the region of the source image 35. As a matter of principle, this leads to a displacement of the field facet image 26 relative to the object field 5 along the y-direction, which is visualized by a double-headed arrow 57 in Figure 14. To compensate for this displacement 57, the angle relation between the normal n and the direction of the chief ray 56 is updated by way of the fine actuator system 29 of the pupil facet 23 such that the location of the field facet image 26 relative to the object field 5 is maintained independently of the displacement 54 of the source image 52.

Thus, overall, a method for adjusting the facet mirrors 20, 22 can be carried out by means of the relative source position sensor 53, in which method the relative position of the source volume 52 relative to the collector 17 is initially measured with the aid of the relative source position sensor 53.

By way of example, the relative source position sensor 53 can be realized as a camera which captures the source volume 52 in imaging fashion. A plurality of such cameras can also be used such that the relative position of the source volume 52 in space can be captured. In particular, this capture can be implemented in real-time and with a high time resolution such that the relative source position sensor 53 can be part of a real-time closed-loop controlled updating method.

Subsequently, the fine actuator system 29 of the tilt actuator system 27 of the respective pupil facet 23 is firstly set in such a way that, on the basis of the relative source position measurement result, a specified position of the assigned illumination channel 25 on the object plane 6 is reached.

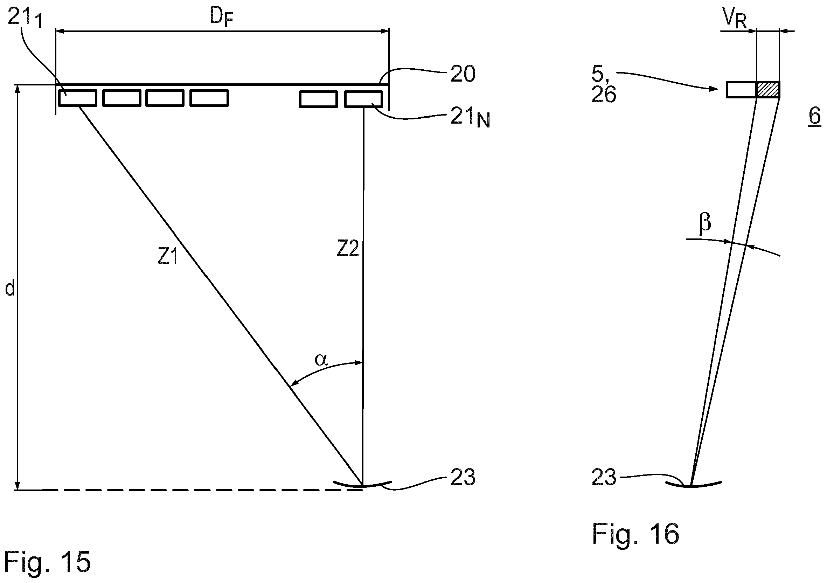

Below, estimates relating to the orders of magnitude of, firstly, the coarse tilt angle range which must be specified by way of the coarse actuator system mode of operation of the tilt actuator system 27 and, secondly, the fine tilt angle range which must be specified by way of the fine actuator system mode of operation of the tilt actuator system 27 are made on the basis of Figures 15 and 16.

Figure 15 schematically illustrates a row of field facets $21_1$ to $21_N$ of the field facets $21_i$ (i=1, 2, ... N) of the field facet mirror 20, which specify a maximum diameter $D_F$ of the far field of the light source 3 in the arrangement region of the field facet mirror 20.

Shown is the extreme situation where, firstly, the field facet $21_1$ in the region of the left-hand side of the far field is assigned (Z1) to a pupil facet and, secondly, the field facet $21_N$ on the right-hand side of the far field is assigned (Z2) to the same pupil facet 23. On account of the diameter $D_F$ of the far field, an angle $\alpha$ arises here between the illumination channels of the assignments Z1, Z2, which must be compensated in the coarse actuator system mode of operation of the tilt actuator system 27 of the pupil facet 23.

Figure 16 shows a tilt angle $\beta$ of the pupil facet 23, which is spanned by two possible positions of a facet image in the object field 5. The field facet image 26 is indicated in the object field 5 in Figure 16. Under the assumption that the images of the field facets $21_i$ have a similar size to the field facets themselves and if the field facet image 26 is intended to be displaced by a fraction $V_R$ by the fine actuator system 29, it is possible to derive the ratio. Here, for simplification, the assumption is made that a distance d between an arrangement plane of the field facet mirror 20 and the pupil facet 23 on the one hand and a distance between the pupil facet 23 and the object plane 6 on the other hand are approximately the same size.

1. Typical ratio for x-displacements:

$$5 \text{ field facets} = D_F, \; V_R = 1/10, \; \frac{\tan(\alpha)}{\tan(\beta)} \sim 50$$

2. Typical ratio for y-displacements (along scan direction):

$$30 \text{ field facets} = D_F, \; V_R = 1/2, \; \frac{\tan(\alpha)}{\tan(\beta)} \sim 60$$

Thus, a maximum coarse tilt angle range to be specified is typically greater than a maximum fine tilt angle range to be specified by a factor of 50 to 60.

During the projection exposure, the reticle 7 and the wafer 13, which bears a coating that is light-sensitive to the EUV illumination light 16, are provided. Subsequently, at least one portion of the reticle 7 is projected onto the wafer 13 with the aid of the projection exposure apparatus 1. Finally, the light-sensitive layer on the wafer 13 that has been exposed with the EUV illumination light 16 is developed. A microstructured or nanostructured component, for example a semiconductor chip, is produced in this way.

The exemplary embodiments described above were described on the basis of EUV illumination. As an alternative to EUV illumination, use can also be made of UV illumination or VUV illumination, for example illumination light with a wavelength of 193 nm.

## Claims

1. Pupil facet mirror (22) for an illumination optical unit (4) of a projection exposure apparatus (1),

   - wherein, in addition to the pupil facet mirror (22), the illumination optical unit (4) comprises a field facet mirror (20) with a plurality of switchable field facets (21),
   - wherein an illumination channel (25) is specified by means of one respective field facet (21) of the field facet mirror (20) and one respective pupil facet (23) of the pupil facet mirror (22), illumination light (16) being guided by means of said illumination channel to an object field (5) in an object plane (6) of the projection exposure apparatus (1) via the field facet (21) and the pupil facet (23), with images (26, 39, 40) of the field facets (21) being imaged in overlaid fashion into the object field (5) via the pupil facets (23),
   - wherein a plurality of tiltable pupil facets (23) belong to the pupil facets (23) of the pupil facet mirror (22),
   - wherein each of the tiltable pupil facets (23) interacts with a tilt actuator system (27) of the pupil facet mirror (22), said tilt actuator system comprising:

     -- a coarse actuator system mode of operation (28) for specifying a coarse tilt angle of the tiltable pupil facet (23) as a result of an illumination channel assignment of this tiltable pupil facet (23) to a field facet (21),
     -- a fine actuator system mode of operation (29) for specifying a fine tilt angle of the tiltable pupil facet (23) for specifying a relative position of the field facet image (26, 39, 40) of the illumination channel (25) of the tiltable pupil facet (23) relative to the object field (5).

2. Pupil facet mirror according to Claim 1, **characterized by** such an embodiment of the tilt actuator system (27) that a maximum specifiable coarse tilt angle range is greater than a maximum specifiable fine tilt angle range by at least a factor of 10.

3. Illumination optical unit (4) comprising a pupil facet mirror (21) according to Claim 1 or 2 and a field facet mirror (20).

4. Illumination system (2) comprising an illumination optical unit (4) according to Claim 3.

5. Illumination system according to Claim 4, **characterized by** at least two energy sensors (30, 31) which are arranged separately from one another and which measure illumination energy of the illumination light (16) in the object plane (6) at two sensor locations, the object field (5) being arranged therebetween.

6. Illumination system according to Claim 4 or 5, **characterized by** a field intensity specification device (42) arranged in the region of the field plane (6) of the projection exposure apparatus (1) and comprising a plurality of shadowing fingers (41) which are displaceable by actuator by means of a displacement actuator system (43) and which can be inserted into the illumination channels (25) from the side by means of the displacement actuator system (43).

7. Illumination system according to any one of Claims 4 to 6, **characterized by** a far field sensor (51) for the spatially resolved far field measurement of an illumination intensity of a light source (3) of the illumination system (2).

8. Illumination system according to any one of Claims 4 to 7, **characterized by** a relative source position sensor (53) for determining a relative position of a source volume (52) of a light source (3) of the illumination system (2) relative to a collector (17) of the illumination system (2).

9. Illumination system according to any one of Claims 4 to 8, **characterized in that**, in addition to a switching actuator system (33), each of the switchable field facets (21) comprises a fine tilt actuator system (34) for specifying a fine tilt angle of the field facet (21) for the purposes of specifying a relative position of the illumination channel (25) relative to the pupil facet (23) assigned via the illumination channel (25).

10. Projection exposure apparatus comprising an illumination system according to any one of Claims 4 to 9.

11. Method for adjusting at least one facet mirror (20, 22) of the illumination system (2) according to any one of Claims 5 to 9, including the following steps:

  - specifying illumination channels (25) intended to impinge a first (30) of the two energy sensors (30, 31),
  - specifying illumination channels (25) intended to impinge the second (31) of the two energy sensors (30, 31),
  - setting the fine actuator system (29) of the tilt actuator system (27) for the pupil facets (23) assigned to the specified illumination channels (25), in such a way that the specified impingement of the respective energy sensors (30, 31) arises.

12. Method for adjusting at least one facet mirror (20, 22) of the illumination system (2) according to any one of Claims 6 to 9, including the following steps:

  - selecting a position of a shadowing finger (41) of the field intensity specification device (42),
  - selecting at least one illumination channel (25),
  - selecting the fine actuator system mode of operation (29) of the tilt actuator system (27),
  - setting (29) the tilt actuator system (27) for the pupil facets (23) assigned to the at least one illumination channel (25), in such a way in the fine actuator system mode of operation (29) that a specified relative position is reached between a free end (46) of the shadowing finger (41) and an edge (44) of the illumination channel (25) facing this free end (46).

13. Method according to Claim 12, **characterized in that** a tilt about an axis arranged parallel to a longitudinal axis of the shadowing finger (41) is implemented during the fine actuator system adjustment.

14. Method for adjusting at least one facet mirror (20, 22) of the illumination system (2) according to any one of Claims 7 to 9, including the following steps:

  - measuring a far field of the light source (3) of the illumination system (2) in spatially resolved fashion using the far field sensor (51),
  - selecting an illumination channel assignment of field facets (21) and pupil facets (23) assigned thereto via the respective illumination channel (25), in such a way that a specified intensity illumination of the object field (5) from the direction of the respective pupil facet (23) arises when the far field measurement result is used as a basis,
  - selecting the coarse actuator system mode of operation (28) of the tilt actuator system (27),
  - switching the respective field facet (21) and setting the tilt actuator system (27) for the pupil facet (23) in such a way in the coarse actuator system mode of operation (28) that the selected illumination channel assignment arises.

15. Method for adjusting at least one facet mirror (20, 22) of the illumination system (2) according to Claim 8 or 9, including the following steps:

  - measuring the relative position of the source volume (52) of the light source (3) of the illumination system (2) relative to the collector (17) of the illumination system (2) using the relative source position sensor (53),
  - setting the fine tilt actuator system (34) for the field facets (22) and/or the fine actuator system (29) of the tilt actuator system (27) for the pupil facets (23) assigned to a respective illumination channel (25), in such a way in the fine actuator system mode of operation (29) that a specified position of the illumination channel (25) is achieved, firstly on the pupil facets (23) and secondly relative to the object field (5), using the relative source position measurement result as a basis.

**Patentansprüche**

1. Pupillenfacettenspiegel (22) für eine Beleuchtungsoptik (4) einer Projektionsbelichtungsanlage (1),

   - wobei die Beleuchtungsoptik (4) zusätzlich zu dem Pupillenfacettenspiegel (22) einen Feldfacettenspiegel (20) mit einer Vielzahl von schaltbaren Feldfacetten (21) umfasst,
   - wobei mittels einer jeweiligen Feldfacette (21) des Feldfacettenspiegels (20) und einer jeweiligen Pupillenfacette (23) des Pupillenfacettenspiegels (22) ein Beleuchtungskanal (25) spezifiziert wird, wobei Beleuchtungslicht (16) über die Feldfacette (21) und die Pupillenfacette (23) zu einem Objektfeld (5) in einer Objektebene (6) der Projektionsbelichtungsanlage (1) geführt wird, wobei Bilder (26, 39, 40) der Feldfacetten (21) einander überlagernd über die Pupillenfacetten (23) in das Objektfeld (5) abgebildet werden,
   - wobei eine Vielzahl neigbarer Pupillenfacetten (23) zu den Pupillenfacetten (23) des Pupillenfacettenspiegels (22) gehört,
   - wobei jede der neigbaren Pupillenfacetten (23) mit einem Neigungsaktuatorsystem (27) des Pupillenfacettenspiegels (22) zusammenwirkt, das Neigungsaktuatorsystem Folgendes umfassend:

     - eine grobe Betriebsart des Aktuatorsystems (28) zum Spezifizieren eines groben Neigungswinkels der neigbaren Pupillenfacette (23) als Ergebnis einer Beleuchtungskanalzuordnung dieser neigbaren Pupillenfacette (23) zu einer Feldfacette (21),
     - eine feine Betriebsart des Aktuatorsystems (29) zum Spezifizieren eines feinen Neigungswinkels der neigbaren Pupillenfacette (23) zum Spezifizieren einer relativen Position des Feldfacettenbildes (26, 39, 40) des Beleuchtungskanals (25) der neigbaren Pupillenfacette (23) relativ zum Objektfeld (5).

2. Pupillenfacettenspiegel nach Anspruch 1, **gekennzeichnet durch** eine derartige Ausführungsform des Neigungsaktuatorsystems (27), dass ein maximal spezifizierbarer grober Neigungswinkelbereich um mindestens einen Faktor von 10 größer ist als ein maximal spezifizierbarer feiner Neigungswinkelbereich.

3. Beleuchtungsoptik (4), einen Pupillenfacettenspiegel (21) nach Anspruch 1 oder 2 und einen Feldfacettenspiegel (20) umfassend.

4. Beleuchtungssystem (2), eine Beleuchtungsoptik (4) nach Anspruch 3 umfassend.

5. Beleuchtungssystem nach Anspruch 4, **gekennzeichnet durch** mindestens zwei Energiesensoren (30, 31), die getrennt voneinander angeordnet sind und die Beleuchtungsenergie des Beleuchtungslichts (16) in der Objektebene (6) an zwei Sensororten messen, wobei das Objektfeld (5) dazwischen angeordnet ist.

6. Beleuchtungssystem nach Anspruch 4 oder 5, **gekennzeichnet durch** eine Feldintensitätsspezifikationsvorrichtung (42), die im Bereich der Feldebene (6) der Projektionsbelichtungsanlage (1) angeordnet ist und mehrere Abschattungsfinger (41) umfasst, die durch einen Aktuator mittels eines Verlagerungsaktuatorsystems (43) verlagert werden können und die mittels des Verlagerungsaktuatorsystems (43) von der Seite in die Beleuchtungskanäle (25) eingeführt werden können.

7. Beleuchtungssystem nach einem der Ansprüche 4 bis 6, **gekennzeichnet durch** einen Fernfeldsensor (51) zur räumlich aufgelösten Fernfeldmessung einer Beleuchtungsintensität einer Lichtquelle (3) des Beleuchtungssystems (2).

8. Beleuchtungssystem nach einem der Ansprüche 4 bis 7, **gekennzeichnet durch** einen Quellenrelativpositionssensor (53) zur Bestimmung einer relativen Position eines Quellenvolumens (52) einer Lichtquelle (3) des Beleuchtungssystems (2) relativ zu einem Kollektor (17) des Beleuchtungssystems (2).

9. Beleuchtungssystem nach einem der Ansprüche 4 bis 8, **dadurch gekennzeichnet, dass** jede der schaltbaren Feldfacetten (21) zusätzlich zu einem Schaltaktuatorsystem (33) ein feines Neigungsaktuatorsystem (34) zum Spezifizieren eines feinen Neigungswinkels der Feldfacette (21) zum Zweck des Spezifizierens einer relativen Position des Beleuchtungskanals (25) in Bezug zur Pupillenfacette (23) umfasst, die über den Beleuchtungskanal (25) zugeordnet ist.

10. Projektionsbelichtungsanlage, ein Beleuchtungssystem nach einem der Ansprüche 4 bis 9 umfassend.

11. Verfahren zum Einstellen mindestens eines Facettenspiegels (20, 22) des Beleuchtungssystems (2) nach einem der Ansprüche 5 bis 9, die folgenden Schritte umfassend:

   - Spezifizieren von Beleuchtungskanälen (25), die vorgesehen sind, einen ersten (30) der beiden Energiesensoren (30, 31) zu bestrahlen,
   - Spezifizieren von Beleuchtungskanälen (25), die vorgesehen sind, den zweiten (31) der beiden Energiesensoren (30, 31) zu bestrahlen,
   - Einstellen des Feinaktuatorsystems (29) des Neigungsaktuatorsystems (27) für die Pupillenfacetten (23), die den spezifizierten Beleuchtungskanälen (25) zugeordnet sind, auf eine derartige Weise, dass die spezifizierte Bestrahlung auf den jeweiligen Energiesensoren (30, 31) entsteht.

12. Verfahren zum Einstellen mindestens eines Facettenspiegels (20, 22) des Beleuchtungssystems (2) nach einem der Ansprüche 6 bis 9, die folgenden Schritte umfassend:

   - Auswählen einer Position eines Abschattungsfingers (41) der Feldintensitätsspezifikationsvorrichtung (42),
   - Auswählen mindestens eines Beleuchtungskanals (25),
   - Auswählen der feinen Betriebsart des Aktuatorsystems (29) des Neigungsaktuatorsystems (27),
   - Einstellen (29) des Neigungsaktuatorsystems (27) für die Pupillenfacetten (23), die dem mindestens einen Beleuchtungskanal (25) zugeordnet sind, auf eine derartige Weise in der feinen Betriebsart des Aktuatorsystems (29), dass eine spezifizierte relative Position zwischen einem freien Ende (46) des Abschattungsfingers (41) und einem Rand (44) des Beleuchtungskanals (25), der diesem freien Ende (46) zugewandt ist, erreicht wird.

13. Verfahren nach Anspruch 12, **dadurch gekennzeichnet, dass** eine Neigung um eine Achse, die parallel zu einer Längsachse des Abschattungsfingers (41) angeordnet ist, während der Einstellung des Feinaktuatorsystems implementiert wird.

14. Verfahren zum Einstellen mindestens eines Facettenspiegels (20, 22) des Beleuchtungssystems (2) nach einem der Ansprüche 7 bis 9, die folgenden Schritte umfassend:

   - räumlich aufgelöstes Messen eines Fernfelds der Lichtquelle (3) des Beleuchtungssystems (2) unter Verwendung des Fernfeldsensors (51),
   - Auswählen einer Beleuchtungskanalzuordnung von Feldfacetten (21) und Pupillenfacetten (23), welche diesen über den jeweiligen Beleuchtungskanal (25) zugeordnet sind, auf eine derartige Weise, dass eine Beleuchtung mit spezifizierter Intensität des Objektfelds (5) aus der Richtung der jeweiligen Pupillenfacette (23) entsteht, wenn das Fernfeldmessergebnis als Grundlage verwendet wird,
   - Auswählen der groben Betriebsart des Aktuatorsystems (28) des Neigungsaktuatorsystems (27),
   - Schalten der jeweiligen Feldfacette (21) und Einstellen des Neigungsaktuatorsystems (27) für die Pupillenfacette (23) auf eine derartige Weise in der groben Betriebsart des Aktuatorsystems (28), dass die ausgewählte Beleuchtungskanalzuordnung entsteht.

15. Verfahren zum Einstellen mindestens eines Facettenspiegels (20, 22) des Beleuchtungssystems (2) nach Anspruch 8 oder 9, die folgenden Schritte umfassend:

   - Messen der relativen Position des Quellenvolumens (52) der Lichtquelle (3) des Beleuchtungssystems (2) relativ zum Kollektor (17) des Beleuchtungssystems (2) unter Verwendung des Quellenrelativpositionssensors (53),
   - Einstellen des feinen Neigungsaktuatorsystems (34) für die Feldfacetten (22) und/oder des Feinaktuatorsystems (29) des Neigungsaktuatorsystems (27) für die Pupillenfacetten (23), die einem jeweiligen Beleuchtungskanal (25) zugeordnet sind, auf eine derartige Weise in der feinen Betriebsart des Aktuatorsystems (29), dass eine spezifizierte Position des Beleuchtungskanals (25) erstens auf den Pupillenfacetten (23) und zweitens relativ zu dem Objektfeld (5) unter Verwendung des Messergebnisses der relativen Quellenposition als Grundlage erzielt wird.

**Revendications**

1. Miroir à facettes pupillaires (22) pour une unité optique d'éclairage (4) d'un appareil d'exposition par projection (1),

   - en plus du miroir à facettes pupillaires (22), l'unité optique d'éclairage (4) comprenant un miroir à facettes de champ (20) avec une pluralité de facettes de champ commutables (21),
   - un canal d'éclairage (25) étant spécifié au moyen d'une facette de champ respective (21) du miroir à facettes de champ (20) et d'une facette pupillaire respective (23) du miroir à facettes pupillaires (22), une lumière d'éclairage (16) étant guidée au moyen du canal d'éclairage vers un champ objet (5) dans un plan objet (6) de l'appareil d'exposition par projection (1) par l'intermédiaire de la facette de champ (21) et de la facette pupillaire (23), des images (26, 39, 40) des facettes de champ (21) étant imagées en superposition dans le champ objet (5) par l'intermédiaire des facettes pupillaires (23),
   - une pluralité de facettes pupillaires inclinables (23) appartenant aux facettes pupillaires (23) du miroir à facettes pupillaires (22),
   - chacune des facettes pupillaires inclinables (23) interagissant avec un système d'actionneur d'inclinaison (27) du miroir à facettes pupillaires (22), ledit système d'actionneur d'inclinaison comprenant :
   - un mode de fonctionnement de système d'actionneur grossier (28) pour spécifier un angle d'inclinaison grossier de la facette pupillaire inclinable (23) en conséquence d'une attribution de canal d'éclairage de cette facette pupillaire inclinable (23) à une facette de champ (21),
   - un mode de fonctionnement de système d'actionneur fin (29) pour spécifier un angle d'inclinaison fin de la facette pupillaire inclinable (23) pour spécifier une position relative de l'image de facette de champ (26, 39, 40) du canal d'éclairage (25) de la facette pupillaire inclinable (23) par rapport au champ objet (5).

2. Miroir à facettes pupillaire selon la revendication 1, **caractérisé par** un mode de réalisation du système d'actionneur d'inclinaison (27) tel qu'une plage d'angle d'inclinaison grossier maximal spécifiable est supérieure à une plage d'angle d'inclinaison fin maximal spécifiable d'un facteur d'au moins 10.

3. Unité optique d'éclairage (4) comprenant un miroir à facettes pupillaires (21) selon la revendication 1 ou 2 et un miroir à facettes de champ (20).

4. Système d'éclairage (2) comprenant une unité optique d'éclairage (4) selon la revendication 3.

5. Système d'éclairage selon la revendication 4, **caractérisé par** au moins deux capteurs d'énergie (30, 31) qui sont agencés séparément l'un de l'autre et qui mesurent l'énergie d'éclairage de la lumière d'éclairage (16) dans le plan objet (6) à deux emplacements de capteur, le champ objet (5) étant agencé entre eux.

6. Système d'éclairage selon la revendication 4 ou 5, **caractérisé par** un dispositif de spécification d'intensité de champ (42) agencé dans la région du plan de champ (6) de l'appareil d'exposition par projection (1) et comprenant une pluralité de doigts d'ombrage (41) qui sont déplaçables par actionneur au moyen d'un système d'actionneur de déplacement (43) et qui sont insérables dans les canaux d'éclairage (25) depuis le côté au moyen du système d'actionneur de déplacement (43).

7. Système d'éclairage selon l'une quelconque des revendications 4 à 6, **caractérisé par** un capteur de champ lointain (51) pour la mesure de champ lointain spatialement résolue d'une intensité d'éclairage d'une source de lumière (3) du système d'éclairage (2).

8. Système d'éclairage selon l'une quelconque des revendications 4 à 7, **caractérisé par** un capteur de position relative de source (53) pour la détermination d'une position relative d'un volume de source (52) d'une source de lumière (3) du système d'éclairage (2) par rapport à un collecteur (17) du système d'éclairage (2).

9. Système d'éclairage selon l'une quelconque des revendications 4 à 8, **caractérisé en ce que**, en plus d'un système d'actionneur de commutation (33), chacune des facettes de champ commutables (21) comprend un système d'actionneur d'inclinaison fin (34) pour la spécification d'un angle d'inclinaison fin de la facette de champ (21) dans le but de la spécification d'une position relative du canal d'éclairage (25) par rapport à la facette pupillaire (23) attribuée par l'intermédiaire du canal d'éclairage (25).

10. Appareil d'exposition par projection comprenant un système d'éclairage selon l'une quelconque des revendications 4 à 9.

**11.** Procédé de réglage d'au moins un miroir à facettes (20, 22) du système d'éclairage (2) selon l'une quelconque des revendications 5 à 9, comprenant les étapes suivantes :

- la spécification de canaux d'éclairage (25) destinés à frapper un premier (30) des deux capteurs d'énergie (30, 31),
- la spécification de canaux d'éclairage (25) destinés à frapper le deuxième (31) des deux capteurs d'énergie (30, 31),
- le réglage du système d'actionneur fin (29) du système d'actionneur d'inclinaison (27) pour les facettes pupillaires (23) attribuées aux canaux d'éclairage spécifiés (25), de telle manière que la frappe spécifiée des capteurs d'énergie respectifs (30, 31) se produit.

**12.** Procédé de réglage d'au moins un miroir à facettes (20, 22) du système d'éclairage (2) selon l'une quelconque des revendications 6 à 9, comprenant les étapes suivantes :

- la sélection d'une position d'un doigt d'ombrage (41) du dispositif de spécification d'intensité de champ (42),
- la sélection d'au moins un canal d'éclairage (25),
- la sélection du mode de fonctionnement de système d'actionneur fin (29) du système d'actionneur d'inclinaison (27),
- le réglage (29) du système d'actionneur d'inclinaison (27) pour les facettes pupillaires (23) attribuées à l'au moins un canal d'éclairage (25), de telle manière dans le mode de fonctionnement de système d'actionneur fin (29) qu'une position relative spécifiée est atteinte entre une extrémité libre (46) du doigt d'ombrage (41) et un bord (44) du canal d'éclairage (25) orienté vers cette extrémité libre (46).

**13.** Procédé selon la revendication 12, **caractérisé en ce qu'**une inclinaison autour d'un axe agencé parallèlement à un axe longitudinal du doigt d'ombrage (41) est mise en œuvre pendant le réglage du système d'actionneur fin.

**14.** Procédé de réglage d'au moins un miroir à facettes (20, 22) du système d'éclairage (2) selon l'une quelconque des revendications 7 à 9, comprenant les étapes suivantes :

- la mesure d'un champ lointain de la source de lumière (3) du système d'éclairage (2) de manière spatialement résolue en utilisant le capteur de champ lointain (51),
- la sélection d'une attribution de canaux d'éclairage de facettes de champ (21) et de facettes pupillaires (23) attribuées à celles-ci par l'intermédiaire du canal d'éclairage respectif (25), de telle manière qu'un éclairage d'intensité spécifiée du champ objet (5) depuis la direction de la facette pupillaire respective (23) se produit lorsque le résultat de la mesure de champ lointain est utilisé comme base,
- la sélection du mode de fonctionnement de système d'actionneur grossier (28) du système d'actionneur d'inclinaison (27),
- la commutation de la facette de champ respective (21) et le réglage du système d'actionneur d'inclinaison (27) pour la facette pupillaire (23) de telle manière dans le mode de fonctionnement de système d'actionneur grossier (28) que l'attribution de canaux d'éclairage sélectionnée se produit.

**15.** Procédé de réglage d'au moins un miroir à facettes (20, 22) du système d'éclairage (2) selon la revendication 8 ou 9, comprenant les étapes suivantes :

- la mesure de la position relative du volume source (52) de la source de lumière (3) du système d'éclairage (2) par rapport au collecteur (17) du système d'éclairage (2) en utilisant le capteur de position relative de la source (53),
- le réglage du système d'actionneur d'inclinaison fin (34) pour les facettes de champ (22) et/ou du système d'actionneur fin (29) du système d'actionneur d'inclinaison (27) pour les facettes pupillaires (23) attribuées à un canal d'éclairage respectif (25), de telle manière dans le mode de fonctionnement de système d'actionneur fin (29) qu'une position spécifiée du canal d'éclairage (25) est atteinte, premièrement sur les facettes pupillaires (23) et deuxièmement par rapport au champ objet (5), en utilisant le résultat de la mesure de position relative de la source comme base.

Fig. 1

EP 4 204 902 B1

Fig. 2

Fig. 3

Fig. 4

Fig. 5

Fig. 6

Fig. 7

51   21₁   25₁        22   23₁        z
                                      ↑
                                   y  |
                                      *—→ x

20   21₂   25₂   23₂

Fig. 8

α1        z
           ↑
        y  |
           *—→ x

23₁

Fig. 9

            α2   z
                  ↑
               y  |
                  *—→ x

23₂

Fig. 10

Fig. 11

Fig. 12

Fig. 13

Fig. 14

EP 4 204 902 B1

Fig. 16

Fig. 15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9791785 B
- WO 2011091900 A1
- US 20160342094 A1
- US 20130100429 A1
- US 20100309449 A1
- WO 2019149462 A1
- US 10018917 B
- US 9625827 B
- US 20150042974 A1
- EP 0952491 A2
- US 8705000 B
- DE 102008009600 A1
- US 20060132747 A1
- EP 1614008 B1
- US 6573978 B
- US 20180074303 A1

**Non-patent literature cited in the description**

- **MEMS** ; **MOEMS**. J. of Micro. *Nanolithography*, 2018, vol. 17 (4), 041008, https://doi.org/10.1117/1. JMM.17.4.041008